# EUROPEAN PATENT APPLICATION

(11) **EP 3 923 075 A1**
(43) Date of publication of application: **15.12.2021**
(21) Application number: 20178785.0
(22) Date of filing: 08.06.2020
(51) Int. Cl.: G03F 7/20

(54) **APPARATUS FOR USE IN A METROLOGY PROCESS OR LITHOGRAPHIC PROCESS**

(71) Applicant: ASML Netherlands B.V., 5500 AH Veldhoven (NL)
(72) Inventor: KEULEN, Luuc, 5500 AH Veldhoven (NL); GOSEN, Jeroen, Gerard, 5500 AH Veldhoven (NL); VAN BANNING, Dennis, Herman, Caspar, 5500 AH Veldhoven (NL); ARORA, Sampann, Veldhoven (NL); RONDE, Michaël, Johannes, Christiaan, 5500 AH Veldhoven (NL); KUINDERSMA, Lucas, 5500 AH Veldhoven (NL); DE VOS, Youssef, Karel, Maria, 5500 AH Veldhoven (NL); VAN DE GROES, Henricus, Martinus, Johannes, 5500 AH Veldhoven (NL); KOOIKER, Allard, Eelco, 5500 AH Veldhoven (NL); PRIL, Wouter, Onno, 5500 AH Veldhoven (NL); VAN GEND, Johan, 5500 AH Veldhoven (NL)
(74) Representative: ASML Netherlands B.V.

(57) **Abstract**

The invention provides an apparatus for use in a metrology process or a lithographic process, the apparatus comprising: an object support module adapted to hold an object; a first gas shower arranged on a first side of the object support module and adapted to emit a gas with a first velocity in a first gas direction which is a horizontal direction to cause a net gas flow in the apparatus to be a substantially horizontal gas flow in the first gas direction at least above the object support module.

## Description

### FIELD

The present invention relates to the technical fields of metrology and/or lithography, in particular to the avoiding of particles and/or dirt on the object during such processes. In further embodiments, the invention relates to measurement systems, in particular measurement systems which emit a measurement beam.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer). A metrology tool is for example suitable for measuring properties of the object to which a pattern has been applied, e.g. overlay or critical dimension. An inspection apparatus is for example suitable for inspecting a pattern which has been applied to an object e.g. to a substrate, e.g. to a wafer.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

During a metrology process or during a lithographic process, the object may be arranged on an object support, e.g. while measurements are made with the metrology tool, or while the pattern is projected onto the substrate, or while an inspection tool is inspecting the substrate. During these processes, it is preferred that no particles or dirt is present on the object, as such particles and/or dirt may results in inaccuracies in the process.

US20070071889A1, which is incorporated herein by reference, discloses a lithographic apparatus and method for conditioning an interior space of a device manufacturing apparatus. A measurement system comprising an interferometer is used to determine the position of the substrate support. It is known to provide gas showers which emit preconditioned gas at least along the optical path. In US20070071889A1, two gas showers are provided on opposite sides of an apparatus component.

### SUMMARY

It is an object of the invention to provide an improvement of the prior art or at least an alternative. In particular, it is an object of the invention to reduce the particles or dirt on an object during a metrology process or lithographic process.

This object is achieved with an apparatus for use in a metrology process or a lithographic process, the apparatus comprising: an object support module adapted to hold an object; a first gas shower arranged on a first side of the object support module and adapted to emit a gas with a first velocity in a first gas direction which is a horizontal direction to cause a net gas flow in the apparatus to be a substantially horizontal gas flow in the first gas direction at least above the object support module.

In accordance with the invention, a horizontal gas flow above the object support module is present during operational use. As such, particles and/or dirt that are present on the object are removed by the gas flow. In addition, particles and/or dirt present in the apparatus are prevented from ending up on the object.

In an embodiment, the object support module is moveable at least in a two-dimensional plane, and the apparatus further comprises a first measurement system for determining a position of the object support module in at least a first direction in the two-dimensional plane. The first measurement system is adapted to emit a first measurement beam along an optical path to the object support module. The net gas flow further covers at least a part of the optical path of the first measurement beam. The two-dimensional plane may e.g. be a substantially horizontal plane. Advantageously, the properties of the gas through which first measurement beam travels can be known and/or predetermined, thereby improving accuracy of the determined position of the object support module.

In an embodiment, the apparatus further comprises a gas guiding element adapted to guide the gas on a second side of the object support module, wherein the second side is facing away from the first side. Advantageously, the net gas flow in the apparatus is guided as desired on the second side of the object support module.

In an embodiment, the apparatus further comprises a second gas shower adapted to emit gas with a second velocity in a second gas direction towards a second side of the object support module, wherein the second side is facing away from the first side. Advantageously, the second gas shower ensures that the net gas flow in the apparatus is as desired.

In an embodiment, the second gas direction comprises a vertical component, e.g. a downward component. Advantageously, the gas flow on the second side may be directed vertically, e.g. downward, e.g. towards an exhaust.

In an embodiment, the first velocity is greater than the second velocity, preferably at least five times greater, more preferably at least ten times greater, e.g. at least twenty times greater. Advantageously, the net gas flow is primarily determined by the first gas shower, at least above the object support module.

In an embodiment, the second velocity is between 0.01m/s - 1m/s, preferably between 0.05m/s-0.5m/s, more preferably 0.05-0.2m/s, e.g. 0.1m/s. It has been found that these velocities result in an advantageous net gas flow.

In an embodiment, the first velocity is between 0.5-5m/s, preferably between 1-4m/s, e.g. 2.5m/s. It has been found that these velocities ensure an advantageous net gas flow above the object support module and/or covering the first measurement beam.

In an embodiment, the first velocity is such that a velocity of the net gas flow is at least 1m/s along the optical path of the first measurement beam and/or above the object support module. It has been found that these velocities ensure an advantageous net gas flow above the object support module and/or covering the first measurement beam.

In an embodiment, the first gas shower is adapted to emit gas in a direction oriented at an acute angle relative to a horizontal part of the optical path of the first measurement beam. Optionally, the first gas shower is also adapted to emit gas in a direction oriented at an acute angle relative to a horizontal part of an optical path of a second measurement beam. It has been found that an improved coverage of the optical path can be achieved.

In an embodiment, the first gas shower is adapted to emit gas in a direction oriented parallel to a horizontal direction of the optical path of the first measurement beam. It has been found that an improved coverage of the optical path can be achieved.

In an embodiment, the apparatus further comprises a gas filter arranged at an outlet of the first gas shower, wherein the gas filter is adapted to filter and equalize the gas before the gas is emitted by the first gas shower. Advantageously, only a single component is required for filtering and equalizing.

In an embodiment, the optical path of the first measurement beam comprises a vertical part and a horizontal part, wherein the apparatus comprises an optical element adapted to direct the first measurement beam from the vertical part to the horizontal part. Advantageously, the position of the object support module can be determined from the distance travelled by the first measurement beam in the horizontal part. Optionally, the optical element is a beam splitter.

In an embodiment, the first measurement system comprises an interferometer. Advantageously, the measurement with the interferometer is accurate using the first gas shower.

In an embodiment, the first measurement system is adapted to emit a second measurement beam along a second optical path to the object support module for determining a position of the object support module in a second direction in the two-dimensional plane. Advantageously, the position of the object support module can be determined. The two-dimensional plane may e.g. be a substantially horizontal plane.

In an embodiment, the apparatus further comprises a second object support module adapted to hold a second object, wherein the first gas shower is adapted to cause the net gas flow in the apparatus to be a substantially horizontal gas flow in the first gas direction at least above the second object support module. Advantageously, particles and/or dirt are removed from the second object or prevented from ending up on the second object.

The invention further relates to an apparatus for use in a metrology process or a lithographic process, the apparatus comprising an object support module and optionally a vertical measurement system. Said apparatus may optionally be combined with the apparatus according to the invention as explained above.

In an embodiment, the object support module comprises an object table adapted to hold the object, a long stroke module supporting the object table, a first positioner adapted to move the object table relative to the long stroke module, and a second positioner adapted to move both the object table and the long stroke module. Advantageously, the object can be positioned accurately.

In an embodiment, the apparatus further comprises: a measurement frame, wherein the object support module is adapted to move relative to the measurement frame; and a vertical measurement system for determining a position of the object support module in a substantially vertical direction. The vertical measurement system comprises: at least one contactless sensor arranged on the object support module; and a conductive element for detecting the contactless sensor, wherein the conductive element is arranged on the measurement frame. Advantageously, the position in vertical direction can be determined with a relatively simple vertical measurement system.

In an embodiment, the at least one contactless sensor is arranged on the object table. Advantageously, the position of the object can be derived accurately.

In an embodiment, the at least one contactless sensor is arranged on the long stroke module. Advantageously, less components are arranged on the object table.

In an embodiment, the at least one contactless sensor is a capacitive sensor or an eddy current sensor. It has been found that there are relatively simple sensors with sufficient accuracy.

In an embodiment, the vertical measurement system comprises at least three contactless sensors, wherein the vertical measurement system is adapted to determine a position of the object support module in the vertical direction, a rotation of the object support module around a first horizontal axis, and a rotation of the object support module around a second horizontal axis. Advantageously, the position of the object support module can be determined in three degrees of freedom.

In an embodiment of either of the apparatuses according to the invention, the apparatus is a metrology tool comprising an optics system configured to generate an optical measurement beam and emit the optical measurement beam on the object arranged on the object support module. Advantageously, less particles and/or dirt are present, resulting in less disturbance of the optical measurement beam.

In an embodiment of either of the apparatuses according to the invention, the apparatus is an inspection tool comprising an optics system configured to generate an inspection beam and emit the inspection beam on the object arranged on the object support module. Advantageously, less particles and/or dirt are present, resulting in less disturbance of the inspection beam.

In an embodiment of either of the apparatuses according to the invention, the object comprises a substrate, wherein the apparatus further comprises a mask support for holding a patterning device having a pattern, and projection system for projecting the pattern onto the substrate when the object is arranged on the object support module. Advantageously, less particles and/or dirt are present, resulting in more accurate projection of the pattern.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a detailed view of a part of the lithographic apparatus of Figure 1;
- Figure 3 schematically depicts a position control system;
- Figure 4a schematically depicts a side view of an apparatus according to the invention;
- Figure 4b schematically depicts a top view of the apparatus shown in figure 4a;
- Figure 5 schematically illustrates a gas shower
- Figure 6 schematically illustrates a vertical measurement system according to a first embodiment;
- Figure 7 schematically illustrates a vertical measurement system according to a second embodiment.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

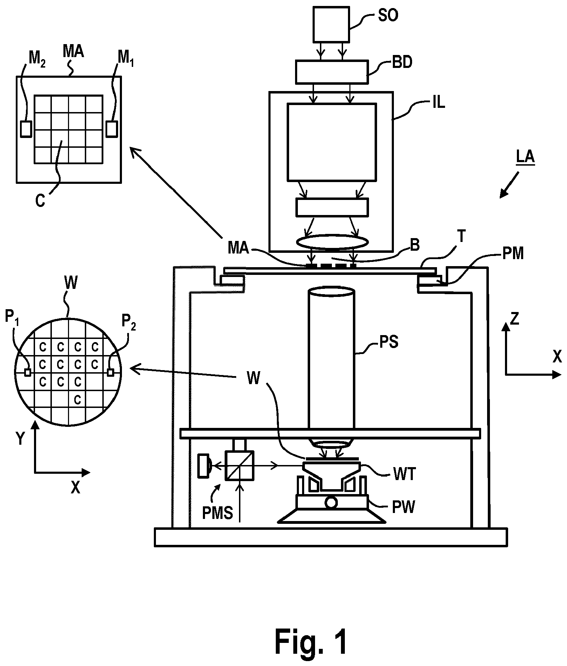

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

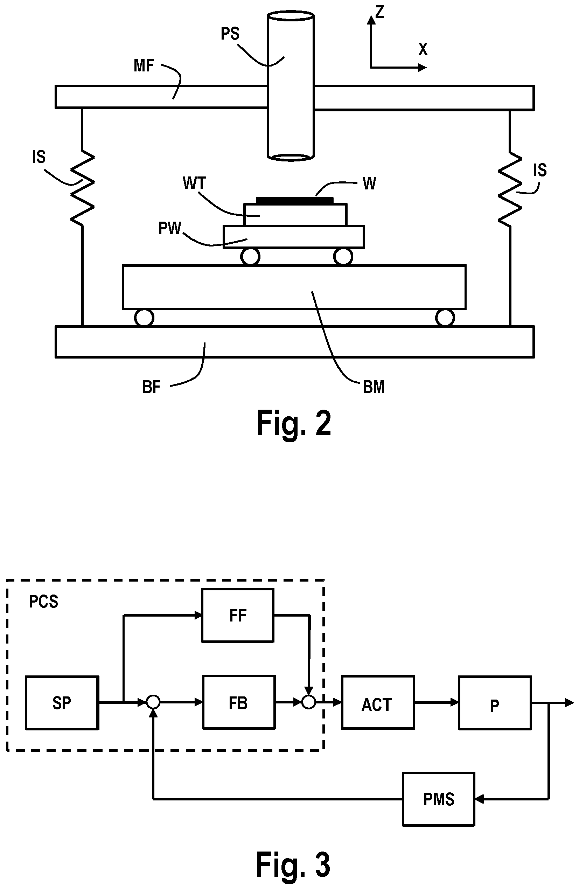

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example,+1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads are arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

After the pattern is projected onto the substrate W, a metrology tool may be used to measure properties of the substrate, e.g. overlay or critical dimension. The present invention may be applied to such a metrology tool. In other embodiments, the present invention can be applied to a lithography apparatus or an inspection tool.

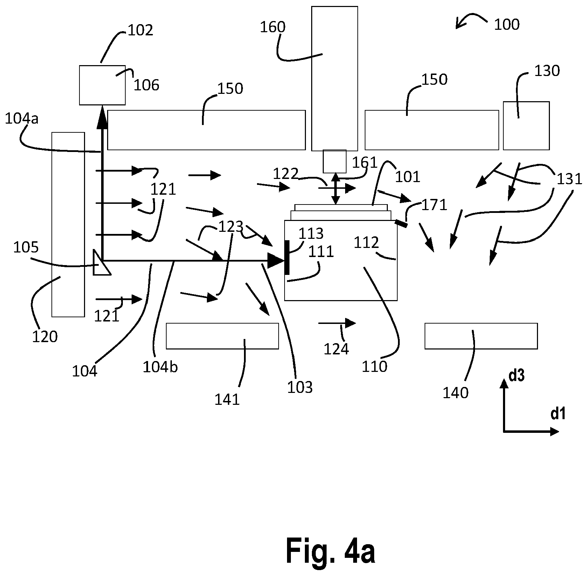

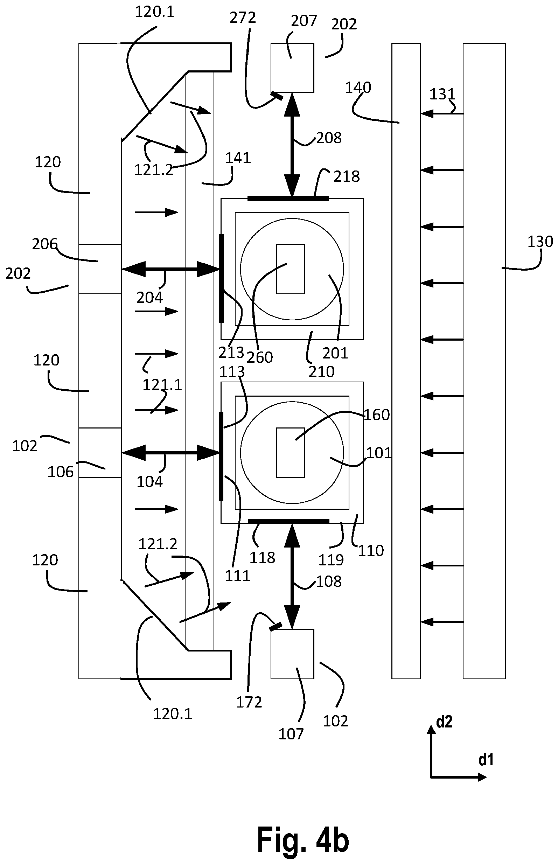

Fig. 4a-4b schematically illustrate an embodiment of the invention. Fig. 4a schematically shows a side view of an embodiment of the invention, and fig. 4b shows schematically shows a top view. The invention relates to an apparatus 100 for use in a metrology process or a lithographic process. The apparatus 100 comprises an object support module 110 adapted to hold an object 101, and a first gas shower 120 arranged on a first side 111 of the object support module 110. The first gas shower 120 is adapted to emit a gas with a first velocity in a first gas direction which is a horizontal direction to cause a net gas flow in the apparatus 100 to be a substantially horizontal gas flow in the first gas direction at least above the object support module 110.

The net gas flow is the resulting gas flow in the apparatus 100. In fig. 4a-4b, the net gas flow within the apparatus 100 is schematically illustrated by means of arrows 121, 122, 123, 124,131. The first gas shower 120 emits the gas as illustrated by arrows 121, which as such illustrate the first gas direction, which in fig. 4a is from left to right. This causes the net gas flow above the object 101, illustrated by arrow 122, to be a substantially horizontal gas flow. The net gas flow as such flows approximately from the first side 111 of the object to an opposite second side 112. This has the advantageous effect that particles and/or dirt are removed from the object 101 or prevented from ending up on the object 101. Such particles and/or dirt could negatively affect the metrology process or lithography process that the object 101 is subjected to in the apparatus 100.

In an embodiment, the object support module 110 is moveable at least in a two-dimensional plane d1, d2, which optionally is a substantially horizontal plane d1,d2. The apparatus 100 further comprises a first measurement system 102 for determining a position of the object support module 110 in at least a first direction d1 in the two-dimensional plane d1, d2. The first measurement system 102 is adapted to emit a first measurement beam 104 along an optical path 104a, 104b to the object support module 110, wherein the net gas flow further covers at least a part of the optical path 104a, 104b of the first measurement beam 104. In this embodiment, the first measurement beam 104 thus travels through gas that has been emitted by the first gas shower 120, as is illustrated in fig. 4a by arrows 121 and 123. This allows to ensure that the properties, e.g. the temperature and/or pressure, of the gas through which the first measurement beam 104 travels are known, e.g. when the gas emitted by the first gas shower 120 is conditioned before being emitted. Said properties may affect e.g. the velocity of the first measurement beam 104, meaning that unknown variations may result in inaccuracies of the determination of the position of the object module 110 in the first direction d1. A position of the object 101 would therefore also be erroneously determined, resulting in inaccuracies in the metrology process or lithographic process to which the object 101 is subjected. Furthermore, in comparison to conventional arrangements wherein gas showers are arranged above the object support module for conditioning the measurement beam, the present invention has the advantage that the components are easier accessible e.g. for maintenance, and a lower cost of goods.

In an embodiment, the apparatus 100 further comprises a gas guiding element 171, which is visible in fig. 4a. The gas guiding element 171 is adapted to guide the gas, and e.g. prevent accumulation or recirculation of gas, on a second side 112 of the object support module 110, wherein the second side 112 is facing away from the first side 111. In the shown example, the gas guiding element 171 is embodied as a spoiler arranged on the second side 112 of the object support module 110, to prevent recirculation vortices on the second side 112 of the object support module 110. Such recirculation vortices may e.g. trap particles or dirt which remain in the apparatus 100.. Fig. 4b shows that the apparatus 100 may comprise further gas guiding elements 172, 272, which will be elaborated further below. Other examples of gas guiding elements may include a second gas shower 130 and/or an exhaust 140, 141, which will be further elaborated below.

In an embodiment, the apparatus 100 further comprises a second gas shower 130. The second gas shower 130 is adapted to emit gas with a second velocity in a second gas direction towards a second side 112 of the object support module 110, wherein the second side 112 is facing away from the first side 111. In fig. 4a, the gas emitted by the second gas shower 130 is illustrated by arrows 131. Although the second gas shower 130 emits the gas towards the second side 112 of the object support module 110, the net gas flow above the object support module 110, illustrated by arrow 122, is still horizontal and flowing from the first side 111 towards the second side 112, and thus primarily determined by the first gas shower 120. The second gas shower 130 ensures that the net gas flow in the apparatus 131 flows as desired. For example, it may be preferred to ensure that there is no accumulation of gas on the second side 112 of the object support module 110, because this may eventually results in a build-up of pressure which may prevent the net gas flow from flowing as desired above the object support module 110. In the shown example, a first exhaust 140 is provided through which the gas flows out of the apparatus 100. The first exhaust 140 may be arranged on the second side 112 of the object support module 110. The second gas shower 130 ensures that the net gas flow is such that the gas flows towards the first exhaust 140. Fig. 4a-4b further shows that optionally a second exhaust 141 is provided on the first side 111 of the object support module 110 and/or at a lower level than the object support module 110. The second exhaust 141 may reduce flow and/or accumulation of gas below the object support module 110, which is illustrated in fig. 4a by arrow 124. The first exhaust 140 and/or the second exhaust 141 further allow to remove dirt and/or particles from the apparatus 100 by means of the gas flow. In an embodiment, the gas emitted by the second gas shower 130 does not cover any measurement beams or their optical paths.

In an embodiment, the second gas direction comprises a vertical component. This may be advantageous to direct the net gas flow towards the first exhaust 140, e.g. when the first exhaust 140 is arranged at a lower level than the second gas shower 130 and/or the object support module 110. The second gas shower 130 is optionally arranged at a higher level than the object support module 110 and/or the fist gas shower 120, as is shown in fig. 4a.

In an embodiment, the first velocity is greater than the second velocity, preferably at least five times greater, more preferably at least ten times greater, e.g. at least twenty times greater. Since the first gas shower 120 emits gas at a greater velocity than the second gas shower 130, the net gas flow is primarily determined by the first gas shower 120, at least above the object support module 110.

In an embodiment, the second velocity is between 0.01m/s - 1m/s, preferably between 0.05m/s-0.5m/s, more preferably 0.05-0.2m/s, e.g. 0.1m/s. It has been found that this is sufficient to ensure that the net gas flow is as desired, in the shown example towards the first exhaust 140.

In an embodiment, the first velocity is between 0.5-5m/s, preferably between 1-4m/s, e.g. 2.5m/s. In an embodiment, the first velocity is such that a velocity of the net gas flow is at least 1m/s along the optical path 104a, 104b of the first measurement beam 104 and/or above the object support module 110. It has been found that in these embodiments the first velocity is sufficient to ensure that no particles and/or dirt end up on the object 101, and/or to ensure that the properties of the gas through which the first measurement beam 104 travels are determined by the gas emitted by the first gas shower 120.

Fig. 4a illustrates that in an embodiment, the optical path 104a, 104b of the first measurement beam 104 comprises a vertical part 104a and a horizontal part 104b, wherein the apparatus 100 comprises an optical element 105, which may e.g. be a mirror, adapted to direct the first measurement beam 104 from the vertical part 104a to the horizontal part 104b. For example, the distance travelled by the measurement beam 104 in the horizontal part 104b may be used to determine the position of the object support module 110 and/or the object 101 in the horizontal direction d1. In other embodiments, the optical path comprise an inclined part, e.g. such that the first measurement beam 104 travels towards the object support module 110 at an acute angle with the horizontal direction d1 and the vertical direction d3. In an embodiment, the first measurement beam 104 may be used to determine a position of the object support module 110 and/or the object 101 in the vertical direction d3.

In an embodiment, the first measurement system 102 comprises an interferometer 106. For example, the interferometer 106 may be adapted to determine the position of the object support module 110 and/or the object 101 based on a distance travelled by the first measurement beam 104. For example, the optical element 105 may be a beam splitter or the first measurement system 102 may comprise a beam splitter on another location. The beam splitter is arranged to split the first measurement beam 104 in two sub-beams, of which one is directed towards the object support module 110. The first measurement system 102 may be adapted to determine the position of the object support module 110 based on a phase-difference between the two sub-beams. The first measurement beam 104 may e.g. be directed by a reflective surface 113 that is arranged on the first side 111 of the object support module 110. In the shown embodiment, the first measurement beam 104 is directed back to the interferometer 106, wherein the interferometer 106 comprises a detector. It is also possible that the detector is arranged on a different position in the apparatus 100, wherein the first measurement beam 104 is directed towards said detector by the reflective surface 113.

Fig. 4b illustrates that in an embodiment, the first measurement system 102 is adapted to emit a second measurement beam 108 along a second optical path to the object support module 110 for determining a position of the first object module in a second direction d2 in the horizontal plane d1,d2. For example, the second measurement beam 108 may be directed towards a third side 119 of the object support module 110. The third side 119 may e.g. be facing in a direction d2 which is perpendicular to a direction d1 in which the first side 111 and/or second side 112 are facing. Optionally, the second measurement beam 108 is emitted by a second interferometer 107 which may be embodied similarly as the interferometer 106. Optionally, the second optical path may comprise a vertical part and a horizontal part, wherein the second measurement beam 108 may e.g. be directed by an optical element (not shown) from the vertical part to the horizontal part, which optical element may e.g. be a beam splitter. Optionally, the object support module 110 may comprise second reflective surface 118 for directing the second measurement beam 108 towards a detector.

In an embodiment, the first gas shower 120 is adapted to emit the gas towards at least a part of the second optical path. In this embodiment, the second measurement beam 108 travels at least partly through the gas emitted by the first gas shower 120, of which the properties may be predetermined and/or known. The accuracy of the determination of the position of the object support module 110 in the second direction d2 can as such be improved. As can be seen in fig. 4b, the second measurement beam 108 may be traveling in a direction which is non-parallel, e.g. substantially perpendicular, to at least a part of the first gas direction.

In an embodiment, the apparatus 100 further comprises a process tool 160, which may e.g. be adapted to be arranged substantially above the object 101 in operational use. For example, the process tool 160 may be used to perform the metrology process of lithographic process to which the object 101 is subjected. The object support module 110 may e.g. be used to position the object 101 below the process tool 160. The process tool 160 may e.g. be adapted to emit a radiation beam 161 onto the object 101, as is illustrated in fig. 4a, and adapted for receiving diffracted light from the object 101.

In an embodiment, the apparatus 100 is a metrology tool, comprising an optics system configured to generate an optical measurement beam 161 and emit the optical measurement beam 161 on the object 101 arranged on the object support module 110. For example, the metrology tool may be used to make overlay and/or critical dimension measurements of an object 101 that has been subjected to a lithographic process. In this embodiment, the optics system may e.g. be arranged in the process tool 160 and/or the optical measurement beam 161 may be directed through the process tool 160.

In an embodiment, the apparatus 100 is an inspection tool comprising an optics system configured to generate an inspection beam 161 and emit the inspection beam 161 on the object 101 arranged on the object support module 110. The inspection tool may e.g. be used to inspect an object 101 that has been subjected to a lithographic process. In this embodiment, the optics system may e.g. be arranged in the process tool 160 and/or the inspection beam 161 may be directed through the process tool 160.

In an embodiment, the object 101 comprises a substrate, wherein the apparatus 100 further comprises a mask support for holding a patterning device having a pattern, and projection system for projecting the pattern onto the substrate when the object 101 is arranged on the object support module 110. The pattern may e.g. be projected onto the substrate by means of the radiation beam 161. For example, the apparatus 100 may be a lithographic apparatus LA as illustrated in figs. 1-3, and/or comprise one or more of the features explained with reference to said lithographic apparatus LA.

Fig. 4b further illustrates that in an embodiment, the apparatus 100 further comprises a second object support module 210 adapted to hold a second object 201. The second object support module 210 is moveable at least in the two-dimensional plane d1, d2, which optionally is a substantially horizontal plane. The first gas shower 120 is adapted to cause the net gas flow in the apparatus 100 to be a substantially horizontal gas flow in the first gas direction at least above the second object support module 210. For example, the apparatus 100 may be a so-called twinstage apparatus. For example, the apparatus 100 may be adapted to subject two objects 101, 201 simultaneously to a metrology or lithographic process. For example, the apparatus 100 may be adapted to subject on of the objects 101, 201 to a metrology or lithographic process while preparing the other of the objects 101, 201 for metrology or lithographic process, e.g. by positioning the object support module 110 or second object support module 210. For these embodiments, the apparatus 100 may comprise a second process tool 260 which may e.g. be adapted to be arranged substantially above the second object 201 in operational use. The second process tool 260 may e.g. be adapted to emit a radiation beam onto the second object 201.

Whereas in the shown embodiment the second support module 210 is provided, it embodiments it is also possible that the object support module 110 comprises a first object table for holding the object 101 and a second object table for holding the second object 201. The first gas shower 120 is adapted to cause the net gas flow in the apparatus 100 to be a substantially horizontal gas flow in the first gas direction at least above the first object table and the second object table.

In an embodiment, the apparatus 100 further comprises a second measurement system 202 for determining a position of the second object support module 210 in at least a fourth direction which is in the two-dimensional plane d1, d2. In the shown embodiment, the fourth direction is parallel to the first direction d1. The second measurement system is adapted to emit a third measurement beam 204 along a third optical path to the second object support module 210. The first gas shower 120 is adapted to cause the net gas flow in the apparatus 100 to cover at least a part of the third optical path of the third measurement beam 204. Optionally, the second measurement system 202 comprises an interferometer 206. Optionally, a third reflective surface 213 is arranged on the second object support module 210 for directing the third measurement beam 204 towards a detector. Optionally, the second measurement system 202 comprises a second interferometer 207 adapted to emit a fourth measurement beam 208 towards the second object support module 210, wherein e.g. a fourth reflective surface 218 is arranged on the second object support module 210 for directing the fourth measurement beam 208 towards a detector.

The gas may be, for example, a conditioned gas, an inert gas, a gas mixture, air, or a different gas. The gas may be ultra clean air of purity class 1, or air of purity class 2 or purity class 3. The temperature of the gas may be relatively stable, for example, stable within 0.10 degrees C. or stable within 0.0010 degrees C. It is known from the prior art how such a thermally stable gas may be provided.

Each of the gas showers 120, 130 may be arranged and configured in various ways. For example, each gas shower 120, 130 may include one or more suitable gas outlet sides to disperse laminar gas flows into the apparatus 100. Each of the outlet sides may be provided, for example, with a porous material, a suitable gas disperser, monofilament cloth, one or more sheets having gas apertures, or a different gas distributor. Each gas shower outlet sides may include one or more layers of one or more materials. The outlet sides may be a wall or wall part of an upstream gas distribution chamber of the respective gas showers, or the outlet sides may be provided in such a wall or a wall part. In the shown embodiment, during use, the gas flows 121, 131 flow substantially perpendicularly from the respective outlet sides. In an embodiment, each gas shower 120, 130, or respective gas outlet side is configured to generate a substantially uniform laminar gas flow from gas that is being supplied to the gas shower during use.

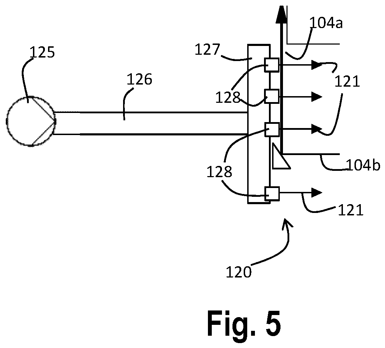

Fig. 5 shows a possible implementation of the first gas shower 120. In an embodiment, the apparatus 100 further comprises a gas filter 127 arranged at an outlet 128 of the first gas shower 120, wherein the gas filter 127 is adapted to filter and equalize the gas before the gas is emitted by the first gas shower 120. In this embodiment, a single gas filter 127 can advantageously be used for the filtering and equalizing, instead of using two separate components, e.g. including a porous material, a suitable gas disperser, monofilament cloth, one or more sheets having gas apertures, or a different gas distributor. It is noted that fig. 5 shows four outlets 128, but in practice any suitable number of outlets 128 may be provided, e.g. one, two, three, five, six, seven, eight, nine, ten, approximately fifty, or approximately a hundred. Fig. 5 further shows that a fan 125 or a compressor may be provided for the making the gas flow through a conduit 126 towards the gas filter 127. The fan 125 may on a suction side (not shown) be fluidly connected to a cleanroom which is used in the metrology process or lithographic process, from which the gas is provided. In other embodiments, the fan 125 may on a suction side be fluidly connected to a fluid reservoir in which the gas is stored, e.g. being pressurized. Optionally, the fluid reservoir and/or the fan 125 is comprised by the apparatus 100. It is also possible that the fan 125 is fluidly connected to a fluid network, which may e.g. be present on the premises where the apparatus 100 is used. A passive or active heat exchanger may further be provided to make the gas thermally stable. Similar embodiments may be applied to the second gas shower.

Fig. 4b further illustrates that in an embodiment, the first gas shower 120 is adapted to emit gas in a direction oriented parallel to a horizontal direction of the optical path of the first measurement beam 104, which in fig. 4b is illustrated by arrows 121.1. Fig. 4b also shows that in an embodiment, the first gas shower 120 is adapted to emit gas in a direction oriented at an acute angle relative to a horizontal part of the optical path of the first measurement beam 104, which in fig. 4b is illustrated by arrows 121.2. In the shown embodiment, the first gas shower 120 comprises two acute oriented portions 120.1 which comprise gas outlets oriented such that the emitted gas is oriented at the acute angle. In the shown embodiment, the direction in which gas emitted by gas outlets in the acute oriented portion 120.1 is directed is also oriented at an acute angle of a horizontal part of the optical path of the second measurement beam 108 of the second interferometer 107. The inventors have found that the coverage of the optical paths of the measurement beams 104, 108 by the emitted gas is advantageous in the shown arrangements for keeping the temperature of the gas substantially constant.

Fig. 4b further shows that air guiding elements 172, 272 provided. The air guiding elements 172, 272 are embodied as spoilers, and prevent that recirculation vortices. Such recirculation vortices would entail pressure variations, which could negatively affect the accuracy of in this case the second measurement beams 108, 208. It is noted that although not shown in fig. 4a-4b, similar air guiding elements may be applied on any location in the apparatus where the gas flow encounters a sharp edge, e.g. to prevent recirculation vortices in the optical path of the first measurement beam 104 or on any side of the object support module 110.

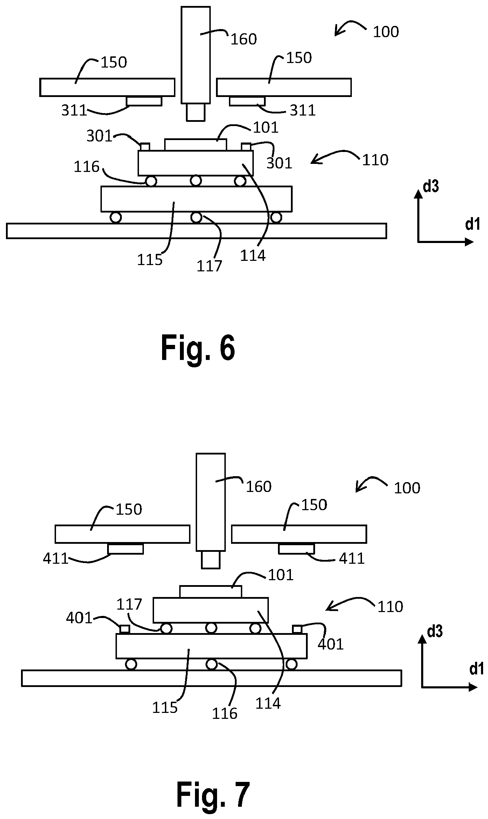

Fig. 6 and fig. 7 illustrate possible embodiments of the object support module 110. In these embodiments, the object support module 110 comprises an object table 114 adapted to hold the object 101, a long stroke module 115 supporting the object table 114, a first positioner 116 adapted to move the object table 114 relative to the long stroke module 115, and a second positioner 117 adapted to move both the object table 114 and the long stroke module 115.

In these embodiments, the second positioner 117 may be used for relatively large movements of the object 101, and the first positioner 116 for smaller movements, which e.g. require more accuracy. The first positioner 116 and/or the second positioner 117 may comprise actuators. Said actuators may e.g. mechanical actuator, piezo-actuators, or contactless actuators, e.g. electromagnetic actuators such as Lorentz-actuators

In an embodiment, the apparatus 100 further comprises a measurement frame 150, wherein the object support module 110 is adapted to move relative to the measurement frame 150. The apparatus 100 further comprises a vertical measurement system for determining a position of the object support module 110 in a substantially vertical direction d3. The vertical measurement system comprises: at least one contactless sensor 301, 401 arranged on the object support module 110; and a conductive element 311, 411 for detecting the contactless sensor 301, 401. The conductive element 311, 411 is arranged on the measurement frame 150.

The vertical measurement system allows to determine the position of the object 101 in the vertical direction d1. The use of contactless sensors 301, 401 has been found advantageous, as it is a relatively simple arrangement which does not disturb the object 101 or the metrology process of lithographic process to which the object 101 is subjected. This is in particular an advantage in view of prior art systems which use e.g. interferometer systems to determine the position in the vertical direction. Furthermore, the vertical measurement system as shown in fig. 6 and fig. 7 may in particular be advantageous for applications where the determination of the position of the object 101 in the vertical direction d3 need not be as accurate as the position in horizontal directions d1,d2. For example, the process tool 160 may be adapted to determine a vertical position of the object 101 and/or adapt the radiation beam such that it is in focus at the height at which the object 101 is arranged.

In the present example, the first gas shower is arranged at the first side of the object support module 110. This is a particular advantage in view of prior art systems that provide gas showers above the object support module 110, because space is provided for arranging the conductive elements 311, 411. Nevertheless, it is explicitly noted that these embodiments of the vertical measurement system may be applied with or without being combined with the first gas shower and/or second gas shower as described herein.

In an embodiment, the at least one contactless sensor 301 is arranged on the object table 114. This ensures that movements of the object table 114 relative to the long stroke module 115 are taken into account when using the vertical measurement system.

In an embodiment, the at least one contactless sensor 401 is arranged on the long stroke module 115. In general, the long stroke module 115 may have more space available to position the at least one contactless sensor.

In an embodiment, the at least one contactless sensor 301, 401 is a capacitive sensor or an eddy current sensor. It has been found that such sensors provide sufficient accuracy, while being relatively simple to implement and without disturbing the metrology process or lithographic process.

In an embodiment, the vertical measurement system comprises at least three contactless sensors 301, 401, wherein the vertical measurement system is adapted to determine a position of the object support module 110 in the vertical direction, a rotation of the object support module 110 around a first horizontal axis, and a rotation of the object support module 110 around a second horizontal axis. Having three contactless sensors 301, 401 allows determining three degrees of freedom. In an embodiment, the vertical measurement system comprises four contactless sensors 301, 401, e.g. each being arranged close to a corner of the object table 114 or long stroke module 115.

It is noted that in embodiments wherein the apparatus 100 comprises a second object support module 210 as e.g. shown in fig. 4b, a second vertical measurement system may be provided for determining the vertical position of said second support module 210. The second vertical measurement system may be embodied analogously to the vertical measurement system explained herein.

Further embodiments are disclosed in the subsequent numbered clauses:
1. Apparatus for use in a metrology process or a lithographic process, the apparatus comprising:
   - an object support module adapted to hold an object,
   - a first gas shower arranged on a first side of the object support module and adapted to emit a gas with a first velocity in a first gas direction which is a horizontal direction to cause a net gas flow in the apparatus to be a substantially horizontal gas flow in the first gas direction at least above the object support module.
2. Apparatus as defined in clause 1, wherein the object support module is moveable at least in a two-dimensional plane, the apparatus further comprising a first measurement system for determining a position of the object support module in at least a first direction in the two-dimensional plane, wherein the first measurement system is adapted to emit a first measurement beam along an optical path to the object support module, wherein the net gas flow further covers at least a part of the optical path of the first measurement beam.
3. Apparatus as defined in clause 1, further comprising a gas guiding element adapted to guide the gas on a second side of the object support module, wherein the second side is facing away from the first side.
4. Apparatus as defined in any of the preceding clauses, further comprising a second gas shower adapted to emit gas with a second velocity in a second gas direction towards a second side of the object support module, wherein the second side is facing away from the first side.
5. Apparatus as defined in clause 4, wherein the second gas direction comprises a vertical component.
6. Apparatus as defined in clause 4 or clause 5, wherein the first velocity is greater than the second velocity.
7. Apparatus as defined in any of the clauses 4-6, wherein the second velocity is between 0.01m/s - 1m/s.
8. Apparatus as defined in any the preceding clauses, wherein the first velocity is between 0.5-5m/s.
9. Apparatus as defined in any of the preceding clauses 2-8, wherein the first velocity is such that a velocity of the net gas flow is at least 1m/s along the optical path of the first measurement beam and/or above the object support module.
10. Apparatus as defined in any of the preceding clauses 2-9, wherein the first gas shower is adapted to emit gas in a direction oriented at an acute angle relative to a horizontal part of the optical path of the first measurement beam.
11. Apparatus as defined in any of the preceding clauses 2-10, wherein the first gas shower is adapted to emit gas in a direction oriented parallel to a horizontal direction of the optical path of the first measurement beam.
12. Apparatus as defined in any of the preceding clauses, further comprising a gas filter arranged at an outlet of the first gas shower, wherein the gas filter is adapted to filter and equalize the gas before the gas is emitted by the first gas shower.
13. Apparatus as defined in any of the preceding clauses, wherein the object support module comprises an object table adapted to hold the object, a long stroke module supporting the object table, a first positioner adapted to move the object table relative to the long stroke module, and a second positioner adapted to move both the object table and the long stroke module.
14. Apparatus as defined in any of the preceding clauses, further comprising:
   - a measurement frame, wherein the object support module is adapted to move relative to the measurement frame, and
   - a vertical measurement system for determining a position of the object support module in a substantially vertical direction, the vertical measurement system comprising:
   - at least one contactless sensor arranged on the object support module,
   - a conductive element for detecting the contactless sensor, wherein the conductive element is arranged on the measurement frame.
15. Apparatus as defined in clause 13 and clause 14, wherein the at least one contactless sensor is arranged on the object table.
16. Apparatus as defined in clause 13 and clause 14, wherein the at least one contactless sensor is arranged on the long stroke module.
17. Apparatus as defined in any of clauses 13-16, wherein the at least one contactless sensor is a capacitive sensor or an eddy current sensor.
18. Apparatus as defined in any of clauses 13-17, wherein the vertical measurement system comprises at least three contactless sensors, wherein the vertical measurement system is adapted to determine a position of the object support module in the vertical direction, a rotation of the object support module around a first horizontal axis, and a rotation of the object support module around a second horizontal axis.
19. Apparatus as defined in any of the preceding clauses, wherein the optical path of the first measurement beam comprises a vertical part and a horizontal part, wherein the apparatus comprises an optical element adapted to direct the first measurement beam from the vertical part to the horizontal part.
20. Apparatus as defined in any of the preceding clauses, wherein the first measurement system comprises an interferometer.
21. Apparatus as defined in any of the preceding clauses, wherein the first measurement system is adapted to emit a second measurement beam along a second optical path to the object support module for determining a position of the object support module in a second direction in the two-dimensional plane.
22. Apparatus as defined in any of the preceding clauses, further comprising a second object support module adapted to hold a second object, wherein the first gas shower is adapted to cause the net gas flow in the apparatus to be a substantially horizontal gas flow in the first gas direction at least above the second object support module.
23. Apparatus as defined in any of the preceding clauses, wherein the apparatus is a metrology tool comprising an optics system configured to generate an optical measurement beam and emit the optical measurement beam on the object arranged on the object support module.
24. Apparatus as defined in any of the preceding clauses, wherein the apparatus is an inspection tool comprising an optics system configured to generate an inspection beam and emit the inspection beam on the object arranged on the object support module.
25. Apparatus as defined in any of the preceding clauses, wherein the object comprises a substrate, wherein the apparatus further comprises a mask support for holding a patterning device having a pattern, and projection system for projecting the pattern onto the substrate when the object is arranged on the object support module.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. Apparatus for use in a metrology process or a lithographic process, the apparatus comprising:
• an object support module adapted to hold an object,
• a first gas shower arranged on a first side of the object support module and adapted to emit a gas with a first velocity in a first gas direction which is a horizontal direction to cause a net gas flow in the apparatus to be a substantially horizontal gas flow in the first gas direction at least above the object support module.

2. Apparatus according to claim 1, wherein the object support module is moveable at least in a two-dimensional plane, the apparatus further comprising a first measurement system for determining a position of the object support module in at least a first direction in the two-dimensional plane, wherein the first measurement system is adapted to emit a first measurement beam along an optical path to the object support module, wherein the net gas flow further covers at least a part of the optical path of the first measurement beam.

3. Apparatus according to any of the preceding claims, further comprising a second gas shower adapted to emit gas with a second velocity in a second gas direction towards a second side of the object support module, wherein the second side is facing away from the first side, wherein the second gas direction comprises a vertical component.

4. Apparatus according to claim 3, wherein the first velocity is greater than the second velocity.

5. Apparatus according to any of the preceding claims, wherein the first gas shower is adapted to emit gas in a direction oriented at an acute angle relative to a horizontal part of the optical path of the first measurement beam.

6. Apparatus according to any of the preceding claims, wherein the first gas shower is adapted to emit gas in a direction oriented parallel to a horizontal direction of the optical path of the first measurement beam.

7. Apparatus according to any of the preceding claims, wherein the object support module comprises an object table adapted to hold the object, a long stroke module supporting the object table, a first positioner adapted to move the object table relative to the long stroke module, and a second positioner adapted to move both the object table and the long stroke module.

8. Apparatus according to any of the preceding claims, further comprising:
• a measurement frame, wherein the object support module is adapted to move relative to the measurement frame, and
• a vertical measurement system for determining a position of the object support module in a substantially vertical direction, the vertical measurement system comprising:
• at least one contactless sensor arranged on the object support module,
• a conductive element for detecting the contactless sensor, wherein the conductive element is arranged on the measurement frame.

9. Apparatus according to claim 7 and claim 8, wherein the at least one contactless sensor is arranged on the object table.

10. Apparatus according to claim 7 and claim 8, wherein the at least one contactless sensor is arranged on the long stroke module.

11. Apparatus according to any of claims 7-10, wherein the vertical measurement system comprises at least three contactless sensors, wherein the vertical measurement system is adapted to determine a position of the object support module in the vertical direction, a rotation of the object support module around a first horizontal axis, and a rotation of the object support module around a second horizontal axis.

12. Apparatus according to any of the preceding claims, wherein the first measurement system comprises an interferometer.

13. Apparatus according to any of the preceding claims, wherein the first measurement system is adapted to emit a second measurement beam along a second optical path to the object support module for determining a position of the object support module in a second direction in the two-dimensional plane.

14. Apparatus according to any of the preceding claims, further comprising a second object support module adapted to hold a second object, wherein the first gas shower is adapted to cause the net gas flow in the apparatus to be a substantially horizontal gas flow in the first gas direction at least above the second object support module.

15. Apparatus according to any of the preceding claims, wherein the apparatus is a metrology tool comprising an optics system configured to generate an optical measurement beam and emit the optical measurement beam on the object arranged on the object support module.
